Europäisches Patentamt

European Patent Office

Office européen des brevets

(11) Veröffentlichungsnummer: **0 141 192**
A2

(12) **EUROPÄISCHE PATENTANMELDUNG**

(21) Anmeldenummer: 84110883.0

(22) Anmeldetag: 12.09.84

(51) Int. Cl.⁴: **H 04 B 9/00**
**H 01 S 3/103**

(30) Priorität: 14.09.83 DE 3333247

(43) Veröffentlichungstag der Anmeldung:
15.05.85 Patentblatt 85/20

(84) Benannte Vertragsstaaten:
AT BE CH DE FR GB IT LI NL SE

(71) Anmelder: Siemens Aktiengesellschaft
Berlin und München Wittelsbacherplatz 2
D-8000 München 2(DE)

(72) Erfinder: Barabas, Udo, Prof. Dr.-Ing.
Gärtnerstrasse 36 b
D-8208 Kolbermoor(DE)

(72) Erfinder: Teuschl, Franz, Dipl.-Ing.
Pollinger Strasse 11
D-8000 München 70(DE)

(54) Optisches Übertragungssystem mit Laserregelung.

(57) Es sind bereits optische Übertragungssysteme für impulsförmige Übertragungssignale bekannt, die eine Regelung des Vorstroms und des Modulationsstroms der Laserdiode mittels eines gegenüber den Übertragungssignalen vergleichsweise niederfrequenten Pilotsignals geringer Amplitude enthalten. Während der Einschaltphase können sich dabei Schwierigkeiten hinsichtlich der Einstellung des Arbeitspunktes der Laserdiode mittels des Vorstroms ergeben. Erfindungsgemäß wird die mittlere Lichtleistung der Laserdiode zur Steuering des Modulationsstroms und die Pilotsignalamplitude zur Steuerung des Vorstroms verwendet, während der Einschaltphase die Vorstromregelung abgeschaltet und ein ungeregelter Zusatzstrom von der auftretenden Regelspannung für den Modulationsstrom abhängt.

FIG 3

EP 0 141 192 A2

SIEMENS AKTIENGESELLSCHAFT

Berlin und München

VPA

83 P 1 6 7 6 E

0141192

Optisches Übertragungssystem mit Laserregelung

Die Erfindung betrifft ein optisches Übertragungssystem für impulsförmige Übertragungssignale mit einem Laserdiodensender, der eine Regelung des Vorstroms und des Modulationsstroms der Laserdiode durch Auswertung des Mittelwertes des erzeugten Lichtes und eines zusätzlich übertragenen, gegenüber den Übertragungssignalen vergleichsweise niederfrequenten Pilotsignals geringer Amplitude enthält, wobei die Regelung über ein mit der Laserdiode optisch gekoppeltes fotoelektrisches Bauelement mit nachgeschaltetem Verstärker aus dem von der Laserdiode abgestrahlten Licht erfolgt.

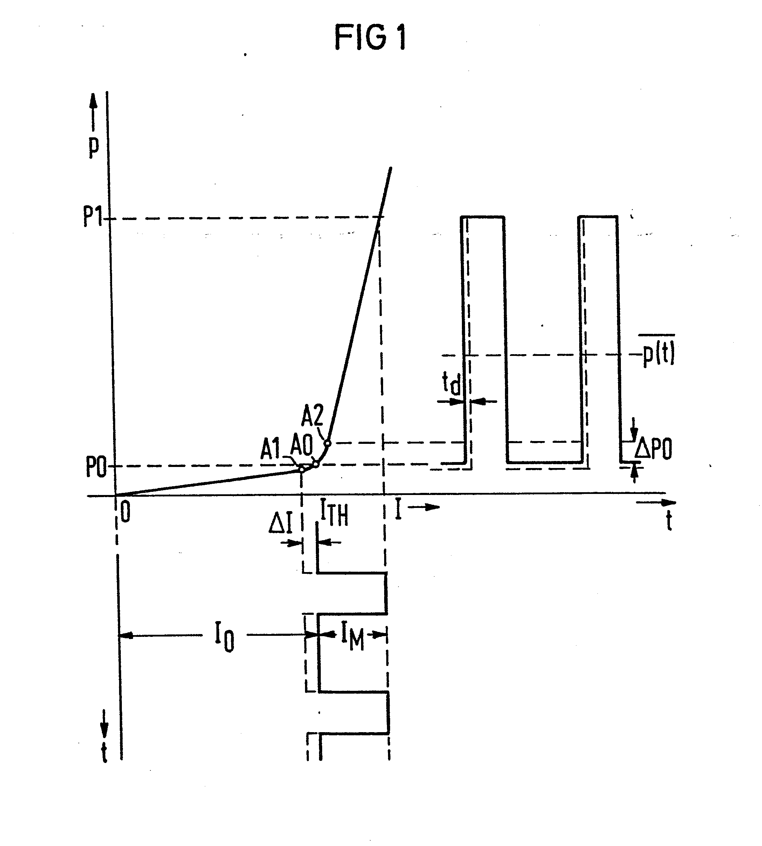

Ein derartiges optisches Übertragungssystem ist aus der DE-OS 31 37 497 bekannt; bei diesem System wird die Laserdiode mit einem Strom beaufschlagt, der aus der Überlagerung eines Vorstroms, eines Modulationsstroms und eines zusätzlichen Regelsignals gebildet ist. Das gegenüber dem Modulationsstrom vergleichsweise niederfrequente Regelsignal mit geringer Amplitude wird beim Stande der Technik gleichzeitig zur Übertragung eines Telemetriesignals verwendet. Zur Regelung ist der Laserdiode benachbart eine Fotodiode als Monitordiode angeordnet, die einen Teil des von der Laserdiode abgestrahlten Lichtes aufnimmt und ein entsprechendes Signal an einen Verstärker abgibt. Die dem Mittelwert des abgestrahlten Lichtes entsprechende Spannung wird zur Regelung des Laserdiodenvorstroms, also zur Einstellung des Arbeitspunktes verwendet, während die mit Hilfe des als Pilotsignal zusätzlich übertragenen Regelsignals ermittelte Kennliniensteilheit zur Regelung des Modulationsstroms verwendet wird. Eine derartige Zuordnung kann sich ungünstig auf das Regelverhalten der Gesamtanordnung auswirken, da die Regelgröße und die
die Regelgröße am meisten beeinflussende Stellgröße,
also beispielsweise die mittlere Lichtleistung und
der Modulationsstrom bzw. das sogenannte Grundlicht
und der Vorstrom nur mittelbar über den jeweils zweiten
Regelkreis miteinander in Beziehung stehen, die beiden
Regelkreise für die beiden zu regelnden Parameter also
in starkem Maße miteinander verkoppelt sind. Zur Erläuterung der verwendeten Bezeichnungen dient die Fig. 1,
die in ihrem oberen Teil links eine typische Laserdiodenkennlinie zeigt, darunter das steuernde Stromsignal der
Laserdiode und rechts von der Laserdiodenkennlinie das
abgegebene Lichtsignal. Auf der Laserdiodenkennlinie
ist der optimale Arbeitspunkt AO eingetragen, im Arbeitspunkt A1 ist der Vorstrom zu klein, so daß sich
wegen einer vergrößerten Verzögerung zwischen dem
steuernden Stromimpuls und dem abgegebenen Licht eine
Verkürzung des Lichtimpulses ergibt, im Arbeitspunkt A2
ist der Vorstrom zu groß, so daß sich ein zusätzlicher
Grundlichtanteil $\Delta$ PO ergibt, was zu einem verringerten
Signal/Störabstand in der Detektordiode am Ende der Lichtwellenleiterstrecke führt. Die mittlere Lichtleistung ist
mit p (t) bezeichnet, das im optimalen Arbeitspunkt AO
erzeugte Grundlicht ist mit PO bezeichnet, während die
maximal abgegebene Lichtleistung mit P1 bezeichnet ist.
Der Strom durch die Laserdiode setzt sich aus dem Vorstrom $I_0$, wobei $I_0$ nicht nur der Arbeitspunktstrom bei AO
sondern allgemein der unterlegte Gleichstrom ist, und
dem Modulationsstrom $I_M$ zusammen. Im Arbeitspunkt A1 ist
der Vorstrom um $\Delta$ I gegenüber dem optimalen Vorstrom zu
klein, mit $I_{IH}$ ist der Schwellstrom der Laserdiode bezeichnet.

Der Nachteil des bekannten Regelkonzepts ist, daß es auf
Grund der Zuordnung von Regelgröße und Stellgröße zu
einer starken Vermaschung beider Regelkreise kommt. Wird
z.B. wegen einer Störung der Arbeitspunkt AO verschoben, so wird zunächst der Modulationsstrom nachgeführt. Diese Nachführung hat aber keinen wesentlichen Einfluß auf den Arbeitspunkt, sondern auf die mittlere Lichtleistung. Erst die Verschiebung der mittleren Lichtleistung führt den Arbeitspunktstrom $I_0$ in den Arbeitspunkt AO zurück.

Eine Störung der mittleren Lichtleistung führt zu analogem Verhalten.

Abhilfe gegen die schwierige Einregelung des Arbeitspunktes erscheint dadurch möglich, daß mit dem Einschalten zunächst ein fester Vorstrom entsprechend dem gewünschten Arbeitspunkt AO vorgegeben wird. Wegen der starken Streuungen der Kennlinien der Laserdioden würde dies eine individuelle Anpassung des Vorstroms an die jeweils verwendete Laserdiode erforderlich machen. Damit ist aber die Vorgabe eines festen Vorstroms und dessen individuelle Einjustierung schlecht möglich.

Die Aufgabe der Erfindung besteht also darin, für ein optisches Übertragungssystem der eingangs erwähnten Art eine Regelung des Laserdiodensenders zu finden. die sich nach dem Einschalten selbsttätig auf den gewünschten Arbeitspunkt einstellt und bei der die beiden Regelkreise für den Arbeitspunkt und die mittlere Lichtleistung voneinander weitgehend entkoppelt sind.

Erfindungsgemäß wird die Aufgabe dadurch gelöst, daß die mittlere Lichtleistung des Laserdiodensenders zur Steuerung des Modulationsstroms und die Pilotsignalamplitude im abgestrahlten Licht zur Steuerung des Vorstroms verwendet wird, daß während der Einschaltphase die Vorstromregelung abgeschaltet ist, bis das Regelsignal für die Vorstromregelung einen vorgegebenen Wert überschreitet und daß ein die Laserdiode durchfließender Zusatzstrom für die Zeit erzeugt wird, während der die Modulationsstromregelung unwirksam ist, da der Sollwert der mittleren Lichtleistung noch nicht erreicht ist.

Ein Hauptvorteil dieser Erfindung besteht also darin, daß die beiden Regelkreise (für den Arbeitspunkt und für die mittlere Lichtleistung) weitgehend entkoppelt sind. Das wird durch die andere Zuordnung zwischen Stell- und Regelgröße erreicht.

Mit Hilfe des Pilotsignals wird die Steilheit der Kennlinie bei einem bestimmten Vorstrom $I_0$ bestimmt und dieser in den Arbeitspunkt AO geregelt. Der Vorstrom $I_0$ hat dabei einen sehr geringen Einfluß auf die mittlere Lichtleistung. Die mittlere Lichtleistung hängt im wesentlichen nur vom Modulationsstrom ab, daher auch diese Zuordnung.

Die erfindungsgemäße Lösung bietet daneben den Vorteil der Verwendbarkeit für hohe Übertragungsgeschwindigkeiten von mehreren 100 Mbit/s bis in den Gigabitbereich hinein. Ein weiterer Vorteil besteht darin, daß alle Nulldurchgänge der resultierenden Pilotamplitude im Arbeitspunkt mit sehr steiler Kennlinie erfolgen und die Arbeitspunkte somit sehr genau und stabil einstellbar sind.

Eine zweckmäßige Weiterbildung des erfindungsgemäßen optischen Übertragungssystems ist im Patentanspruch 2 beschrieben.

Diese Weiterbildung bietet in einfacher Weise die Möglichkeit, die erfindungsgemäße Laserregelung in integrierter Technik aufzubauen.

Die Erfindung soll im folgenden anhand der Zeichnung näher erläutert werden.

In der Zeichnung zeigt

Fig. 1  die Darstellung einer Laserdiodenkennlinie mit einigen dazugehörigen Signalen, die bereits bei der einleitenden Darstellung des Standes der Technik erläutert wurde,

Fig. 2  eine Laserdiodenkennlinie zusammen mit dazugehörigen Signalen sowie Kennlinien zur Arbeitspunkteinstellung,

Fig. 3  das Blockschaltbild einer erfindungsgemäßen Sendeschaltung für ein optisches Übertragungssystem,

Fig. 4  die Detailschaltung eines in der Fig. 3 enthaltenen Hilfskreises und

Fig. 5  Einschaltkennlinien für den Modulationsstrom und den Vorstrom der Laserdiode in einer Sendeschaltung nach Fig. 3.

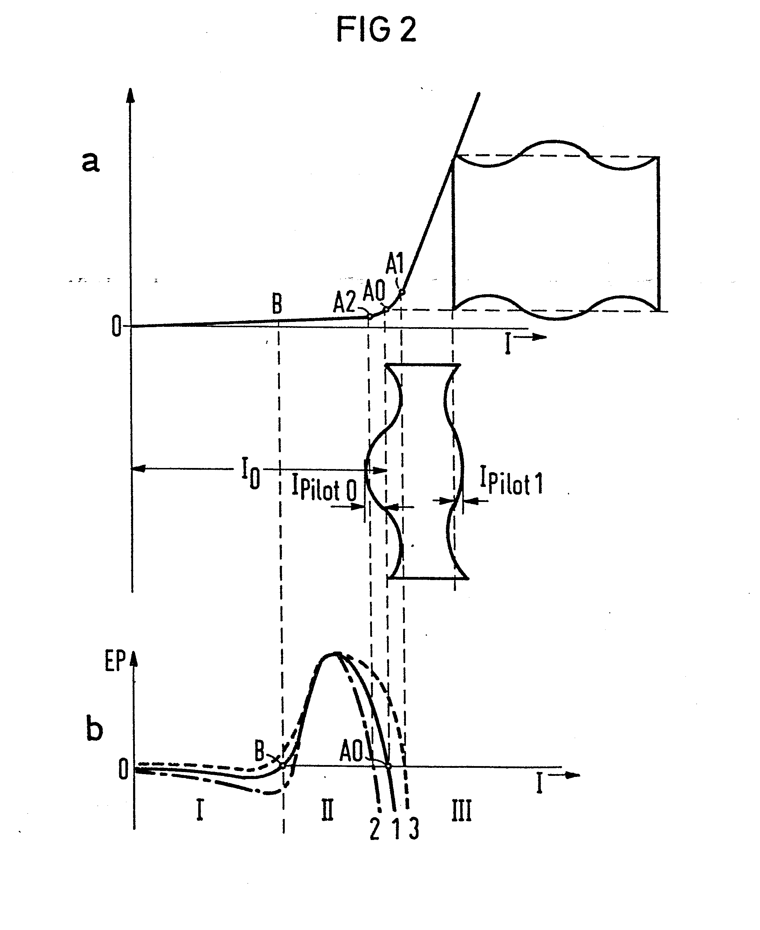

In der Fig. 2a ist wiederum eine typische Laserdiodenkennlinie mit $I_0$, $I_M$, sowie dem gegenphasig aufmodulierten Pilotstrom Ipilot mit dazugehörigem Lichtsignal der Laser und in der Fig. 2b Kennlinien zur Arbeitspunkteinstellung für eine derartige Laserdiode dargestellt. Auf der in der Fig. 2a dargestellten Kennlinie sind wiederum ein mittlerer Arbeitspunkt A0, ein etwas zu hoher Arbeitspunkt A1 und ein zu niedriger Arbeitspunkt A2 markiert. Die Figur 2b zeigt die Abhängigkeit der Amplitude des Pilotsignals (EP) an der Monitordiode vom Vorstrom $I_0$ der Laserdiode. Wird nun eine Laserdiode mit einer Kennlinie nach Bild 2a mit dem dargestellten Pilotsignal Ipilot beaufschlagt und dadurch das Sendesignal z.B. amplitudenmoduliert, so ist an der Monitordiode ein empfängerseitiges Pilotsignal detektierbar, dessen Amplitude in Abhängigkeit vom Vorstrom dem in Fig. 2b mit 1 bezeichnetem Verlauf folgt. Die Amplitude des Pilotsignals ergibt sich aus der Differenz der den log"1"-Zuständen von Modulationsstrom $I_M$ auf modulierten Pilotkomponente (Ipilot1) und der den log"0"-Zuständen aufmodulierten Pilotkomponente (Ipilot 0). Eine Vereinfachung in der Anwendung des Pilotsignals ergibt sich, wenn die Pilotkomponenten Ipilot1 und Ipilot0 so aufeinander abgestimmt sind, daß sich im gewünschten Arbeitspunkt AO beide Pilotkomponenten im Laserlicht zu Null ergänzen. Es braucht dann nur ein. Nullabgleich durchgeführt werden.

Das Einstellen von Ipilot0 und Ipilot1 erfolgt sehr einfach:

a: in den Impulspausen ist der Schalter, mit dem $I_M$ auf die Laserdiode geschaltet wird, geöffnet und es fließt nur $I_0$, - Ipilot0 wird also $I_\theta$ aufmoduliert;

b: während der Signalimpulse von $I_M$ wird deren Amplitude gegenphasig zu Ipilot0 mit Ipilot1 eingestellt.

Werden die Pilotkomponenten Ipilot0 und Ipilot1 wie oben angegeben eingestellt, so folgt die resultierende Pilot- amplitude an der Fotodiode deren in Fig. 2b mit 1 bezeichneten Verlauf mit dem Wert Null im optimalen Arbeitspunkt AO.

Bei Einstellung eines zu niedrigen bzw. eines zu hohen Arbeitspunktes ergibt sich ein Verlauf entsprechend den Kurven 2 bzw. 3. In den dargestellten Verläufen sind drei Bereiche I, II, III unterscheidbar, die durch den stabilen Nullpunkt und den jeweiligen Arbeitspunkt begrenzt sind. Im instabilen Punkt B und beim angestrebten Arbeitspunkt AO verschwindet das empfangsseitig fest- stellbare Pilotsignal, es tritt ein Phasensprung um 180° ein. Dieser Phasensprung entspricht einem Vorzeichenwechsel, so daß sich die Regelrichtung ändert. Die Vorstromregelung wirkt dadurch so, daß jede Ablage des Vorstroms Io vom Arbeitspunkt weg in den Bereich II hinein zu einer Zunahme des Vorstroms, jede Ablage in den Bereich III hinein zu einer Abnahme des Vorstroms führt. Eine Ablage des Vorstroms in den Bereich I hinein führt aber wegen des auftretenden negativen Verzeichens des Empfangspiloten an der Monitordiode zu einer Abnahme des Vorstroms der Laserdiode in den Nullpunkt hinein. Damit ist erkennbar, daß ein Hochregeln des Arbeitspunktes von Null nach A über B hinweg in der Einschaltphase ohne ergänzende Maßnahmen nicht möglich ist.

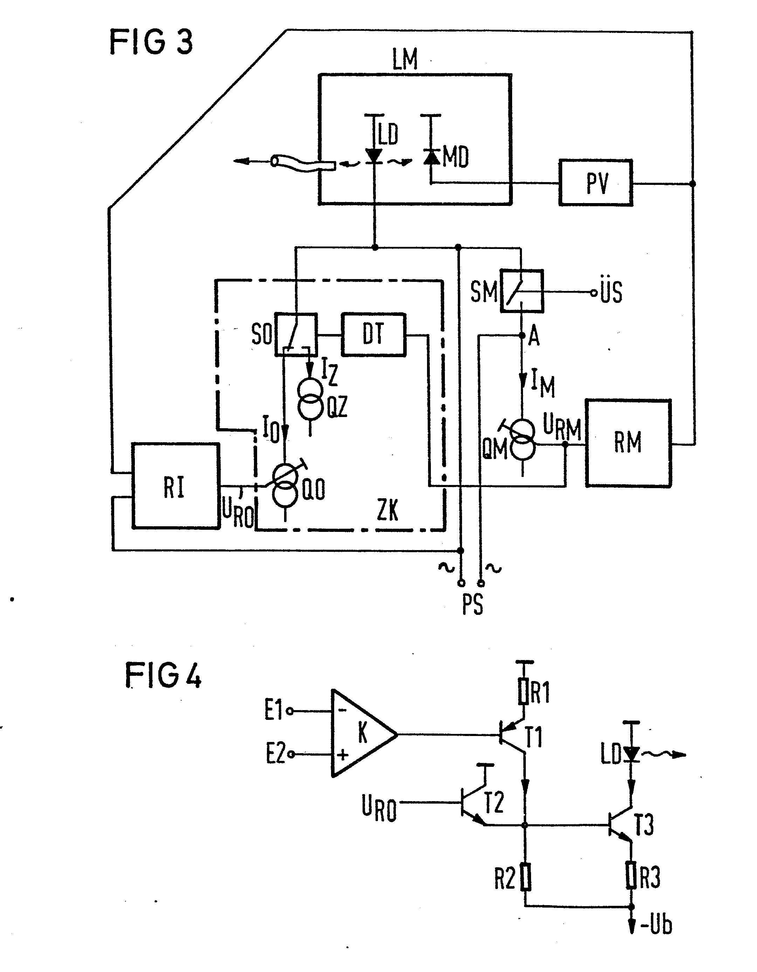

In der Fig. 3 ist der Sendeteil eines optischen Übertragungssystems nach der Erfindung dargestellt, der in einem Lasermodul LM eine Laserdiode LD enthält, an die einerseits eine Glasfaser GF und andererseits eine Monitordiode MD optisch angekoppelt sind. Der Fotostrom der Monitordiode MD wird in einem Verstärker PV verstärkt und in eine Spannung umgewandelt, die an einen Modulationsstromregler RM und an einen Vorstromregler RI abgegeben wird. Im Modulationsstromregler RM wird durch Vergleich der Ausgangsspannung des Verstärkers PV mit einer im Regler intern erzeugten Referenzspannung eine Steuerspannung $U_{RM}$ erzeugt, die eine Modulations-Stromquelle QM steuert. Der Ausgangsstrom $I_M$ dieser Stromquelle wird über einen vom Übertragungssignal ÜS gesteuerten Schalter SM an die Laserdiode LD abgegeben. Beim Übertragungssignal ÜS kann es sich dabei sowohl um ein digitales Signal, beispielsweise ein PCM-Signal, als auch um ein analoges Signal, beispielsweise um ein Impulssignal mit Pulslängenmodulation oder Pulsphasenmodulation handeln. Mit dem Modulationsstromeingang des gesteuerten Schalters SM ist zusätzlich ein Anschluß einer Quelle für ein Pilotsignal PS verbunden, während ein anderer Anschluß dieser Pilotsignalquelle direkt mit der Laserdiode verbunden ist. An den beiden Anschlüssen liegen gegenphasige Komponenten des Pilotsignals. Der Regler RI für die Vorstromregelung der Laserdiode enthält eingangsseitig einen Mischer für den Vergleich des Ausgangssignals des Verstärkers PV mit einem Referenzsignal, wozu diejenige Komponente des Pilotsignals zugeführt wird, die auch direkt an der Laserdiode LD anliegt. Der Regler RI enthält dabei zusätzlich eingangsseitig Filter, durch die sichergestellt wird, daß das sendeseitige Pilotsignal auschließlich mit dem von der Monitordiode MD empfangenen Pilotsignal verglichen wird. Nach Integration mit einer Integrationszeit $\tau_0$ gibt der Vorstromregler RI eine Vorstromregelspannung $U_{RO}$ ab, die zur Regelung einer Stromquelle QO dient. Die Stromquelle QO erzeugt den Laserdiodenvorstrom $I_0$, der über weitere Teile eines Zusatzkreises ZK an die Laserdiode LD weitergeleitet wird.

Der Zusatzkreis ZK enthält neben der erwähnten Stromquelle QO eine Stromquelle QZ zur Erzeugung eines Zusatzstroms $I_Z$, einen Umschalter SO, dessen Ausgang mit der Laserdiode und dessen geschaltete Eingänge mit der Zusatzstromquelle QZ bzw. der Vorstromquelle QO verbunden sind. Außerdem enthält der Zusatzkreis einen Detektor DT, dessen Ausgangssignal den Umschalter SO steuert und dessen Eingang mit dem Ausgang des Modulationsstromreglers RM verbunden ist. Bei Erreichen des maximalen Modulationsstromes $I_{MAX}$ bzw. einer entsprechenden Modulationsregelspannung $U_{RM}$ gibt dieser Detektor DT während des Einschaltvorganges der Laserdiode ein Ausgangssignal ab, durch das der Umschalter SO zum Umschalten auf die Zusatzstromquelle QZ veranlaßt wird.

Der Einschaltvorgang erfolgt in folgender Reihenfolge:

1: allgemeiner Start mit Vorstrom $I_0 = 0$ und Modulationsstrom $I_M = 0$ ;

2: der Modulationsstrom $I_M$ steigt mit größter Anstiegsgeschwindigkeit, der Vorstrom $I_0$ ist dabei 0;

3: der Modulationsstrom hat seinen Maximalwert $I_M = I_{M\,max}$ der Sollwert der mittleren Lichtleistung ist aber noch nicht erreicht, der Umschalter SO schaltet, so daß der Vorstrom $I_0$ gleich dem Zusatzstrom $I_Z$ ist;

4: der Zusatzstrom $I_Z$ steigt mit der Zeitkonstante $\tau_Z$ an, der Zusatzstrom $I_Z$ ist dabei nicht geregelt;

5: der Zusatzstrom $I_Z$ überschreitet den Punkt B auf der Laserdiodenkennlinie, die Vorstromregelung versucht mit dem Vorstrom $I_0$ den Arbeitspunkt AO einzustellen, zu diesem Zweck wird die Spannung $U_{RO}$ hochgeregelt, der Schalter SO wird aber noch nicht umgeschaltet, so daß nach wie vor der Zusatzstrom $I_Z$ fließt;

6: der Detektor RM für die mittlere Lichtleistung zeigt an, daß mit Hilfe von Zusatzstrom und Modulationsstrom der Sollwert der mittleren Lichtleistung erreicht ist. Um den Sollwert trotz ansteigendem ungeregeltem Zusatzstrom $I_Z$ zu halten, regelt der Detektor RD mit Hilfe der Spannung $U_{RM}$ den Modulationsstrom $I_M$ zu kleineren Werten hin, d.h. der Modulationsstrom $I_M$ geht aus der Begrenzung. Dies erkennt der Detektor DT und schaltet mit dem Schalter SO den Zusatzstrom $I_Z$ ab (Zeit : $t_2$ ). In diesem Ausführungsbeispiel steigt der Vorstrom $I_0$ langsamer und später als der Zusatzstrom $I_Z$, so daß bei $I_Z$ gilt $I_0 < I_Z$, Mit Beginn des Abfalls des Zusatzstroms $I_Z$ sinkt die mittlere Lichtleistung, so daß unmittelbar nach dem Abschalten der Zusatzstrom $I_Z$ wieder eingeschaltet wird. Im Prinzip ist dies eine Zweipunktregelung, hier jedoch ein analoger Vorgang, so daß $I_Z$ = konst = $I_{ZM}$ gehalten wird.

7: $I_0$ hat den Wert von $I_{ZM}$ erreicht, damit schaltet $I_{ZM}$ endgültig ab und $I_0$ wird eingeschaltet und regelt den Arbeitspunkt (AO) ein.

In der Fig. 4 ist die Schaltung des Zusatzkreises ZK detailliert dargestellt, Der Zusatzkreis ZK enthält einen Komparator K, dessen erster, negativer Eingang E1 mit dem Ausgang des Modulationsstromreglers RM verbunden ist. Der zweite, positive Eingang E2 des Komparators ist mit einer Referenzspannungsquelle verbunden, während der Ausgang des Komparators mit dem Basisanschluß eines ersten Transistors T1 vom pnp-Typ verbunden ist. Der Emitteranschluß des Transistors T1 ist über einen ersten Widerstand R1 mit Bezugspotential verbunden, während der Kollektoranschluß dieses Transistors mit dem Emitteranschluß eines zweiten Transistors T2 vom npn-Typ, mit dem Basisanschluß eines dritten Transistors T3 vom npn-Typ und über einen Widerstand R2 mit Betriebsspannung -Ub verbunden ist. Der Kollektoranschluß des zweiten Transistors T2 ist mit Bezugspotential verbunden, der Basisanschluß dieses Transistors ist an den Ausgang des Vorstromreglers RI angeschlossen und erhält so die Vorstromregelspannung $U_{RO}$. Der Emitteranschluß des dritten Transistors T3 ist über einen dritten Widerstand R3 mit Betriebsspannung -Ub verbunden, während der Kollektoranschluß dieses Transistors an die Laserdiode LD angeschlossen ist.

Während der Einschaltphase mit $I_M = Ih_{MAX}$ ist die Regelspannung $U_{RM}$ für den Modulationsstrom so hoch, $U_{RB} = U_{RMmax}$ daß sie über der am zweiten Eingang (E2) des Komparators anliegenden Referenzspannung liegt, der Komparator K hält in dieser Phase den ersten Transistor T1 geöffnet. Der Kolle.ktorstrom dieses Transistors erzeugt am zweiten Widerstand R2 einen Spannungsabfall, der den dritten Transistor T3 öffnet und das Fließen eines Zusatzstroms veranlaßt. Die Anstiegsgeschwindig-keit $V_Z$ ergibt sich damit aus der Schaltgeschwindigkeit von T1 und T3. Der zweite Transistor bleibt zunächst gesperrt. Mit dem Überschreiten des Punktes (B) auf der Laserkennlinie (Zeit $t_2$) wächst $U_{RO}$, bis $U_{RO}$ größer ist als die Summe der Basisemitterspannung des zweiten Transistors T2 und des Spannungsabfalls im zweiten Widerstand R2. Damit wird der zweite Transistor T2 geöffnet (t8).

Der Schaltungszwang ist so festgelegt, daß im Umschalt-punkt (tz) $I_0 = I_{Zmax}$ ist. Das ergibt sich, da hier die Spannung an RZ nicht springt. Damit geht $I_Z$ homogen in $I_0$ über und die Laserdiode wird mit keinem springenden Vorstrom belastet.

Das Umschalten des Komparators K zum Abschalten von Zusatzstrom $I_Z$ wird dabei dadurch erreicht, daß mit dem weiteren Anstieg des Vorstroms $I_0$ wegen der konstant gehaltenen mittleren Lichtleistung der Modulationsstrom $I_M$ absinkt und damit auch dessen Regelspannung $U_{RM}$ die Referenzspannung am Komparator K unterschreitet.

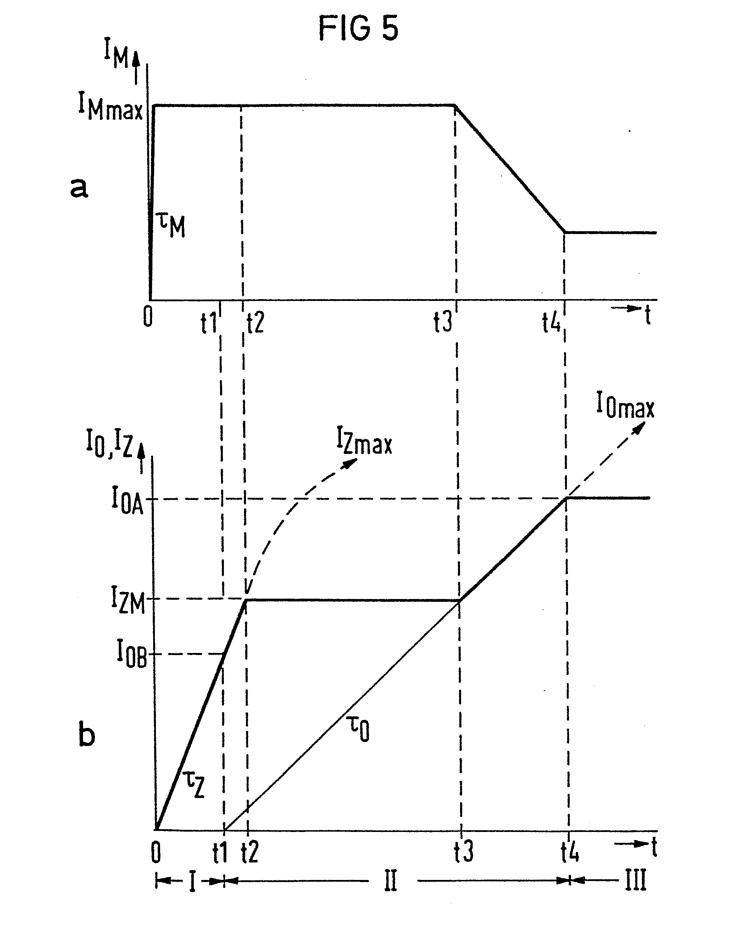

In der Fig. 5 ist das Verhalten des Lasersenders in der Einschaltphase im Hinblick auf den Modulationsstrom und den Vorstrom dargestellt. Unmittelbar nach dem Einschalten steigt der Modulationsstrom $I_M$ mit der vergleichsweise kleinen Zeitkonstante $\tau_M$ auf den Maximalwert. Der Zusatzstrom $I_Z$, der in dieser Phase den Vorstrom bildet, steigt währenddessen mit einer gegenüber $\tau_M$ größeren Zeitkonstante $\tau_Z$ langsamer an. Dabei wird zum Zeitpunkt $t_1$ der Punkt B auf der Kennlinie entsprechend Fig. 2b erreicht. Zum Zeitpunkt $t_2$ ist der eingestellte Sollwert der mittleren Lichtleistung erreicht, so daß nun der Zusatzstrom $I_Z$ nicht mehr weiter ansteigt, während die Regelspannung $U_{RO}$ weiter ansteigt und am Punkte $t_3$ der Transistor T2 eingeschaltet und der Transistor T1 abgeschaltet wird. Mit dem weiteren Anstieg $U_{RO}$ bis zum Zeitpunkt $t_4$ steigt der Vorstrom weiter an und erreicht zum Zeitpunkt $t_4$ den angestrebten Arbeitspunkt AO.

Das beschriebene Verfahren bietet die Möglichkeit, den Arbeitspunkt bei sehr guter Stabilität über den gesamten Bereich der Kennlinienkrümmung zur Optimierung der Systemeigenschaften frei zu wählen und sicher einzustellen.

2 Patentansprüche
5 Figuren

Patentansprüche

1. Optisches Übertragungssystem für impulsförmige Übertragungssignale mit einem Laserdiodensender, der eine Regelung des Vorstroms und des Modulationsstroms der Laserdiode durch Auswertung des Mittelwertes des erzeugten Lichtes und eines zusätzlich übertragenen, gegenüber den Übergangssignalen vergleichsweise niederfrequenten Pilotsignals geringer Amplitude enthält, wobei die Regelung über ein mit der Laserdiode optisch gekoppeltes fotoelektrisches Bauelement mit nachgeschaltetem Verstärker aus dem von der Laserdiode abgestrahlten Licht erfolgt, d a - d u r c h   g e k e n n z e i c h n e t , daß die mittlere Lichtleistung des Laserdiodensenders zur Steuerung des Modulationsstroms und die Pilotsignalamplitude im abgestrahlten Licht zur Steuerung des Vorstroms verwendet wird, daß während der Einschaltphase die Vorstromregelung abgeschaltet ist, bis das Regelsignal für die Vorstromregelung einen vorgegebenen Wert überschreitet und daß ein die Laserdiode durchfliessender Zusatzstrom für die Zeit erzeugt wird, während der die Modulationsstromregelung unwirksam ist, da der Sollwert der mittleren Lichtleistung noch nicht erreicht ist.

2. Optisches Übertragungssystem nach Anspruch 1, d a - d u r c h   g e k e n n z e i c h n e t , daß ein Komparator (KU) vorgesehen ist, an dessen negativem Eingang die den Modulationsstrom steuernde Regelspannung und an dessen positivem Eingang eine Referenzspannung anliegt, daß mit dem Ausgang des Komparators der Basisanschluß eines ersten Transistors (T1) vom pnp-Typ verbunden ist, daß der Emitteranschluß dieses Transistors über einen ersten Widerstand (R1) mit Bezugspotential verbunden ist, daß der Kollektoranschluß dieses Transistors mit dem Emitteranschluß eines zweiten Transistors (T2) vom npn-Typ und über einen zweiten Widerstand (R2) mit Betriebsspannung

0141192

(-Ub) verbunden ist, daß der Basisanschluß des zweiten Transistors (T2) mit einer Quelle für die den Vorstrom der Laserdiode steuernde Regelspannung verbunden ist, daß der Kollektoranschluß dieses Transistors mit Bezugspotential verbunden ist, daß der Emitteranschluß dieses Transistors zusätzlich mit dem Basisanschluß eines dritten Transistors (T3) vom npn-Typ verbunden ist, dessen Emitteranschluß über einen dritten Widerstand (R3) mit der Betriebsspannungsquelle (-Ub) verbunden ist und daß der Kollektoranschluß dieses Transistors (T3) über die Laserdiode (LD) mit Bezugspotential verbunden ist.

FIG 1

# FIG 2

**FIG 3**

**FIG 4**

## FIG 5